# EUROPEAN PATENT SPECIFICATION

(11) **EP 3 051 008 B1**
(45) Date of publication and mention of the grant of the patent: **23.10.2019**
(21) Application number: 14849869.4
(22) Date of filing: 06.08.2014
(51) Int. Cl.: C30B 15/10, C30B 15/14, C30B 29/06

(54) **CRUCIBLE AND INGOT GROWING DEVICE COMPRISING SAME**
TIEGEL UND BLOCKZÜCHTUNGSVORRICHTUNG DAMIT
CREUSET ET DISPOSITIF DE CROISSANCE DE LINGOT COMPRENANT CELUI-CI

(30) Priority: 25.09.2013 KR 20130113770
(43) Date of publication of application: 03.08.2016
(73) Proprietor: SK Siltron Co., Ltd., Gyeongsangbuk-do (KR)
(72) Inventor: JUNG, Han-Sol, Gumi-si Gyeongsangbuk-do 730-340 (KR); KIM, Do-Yeon, Gumi-si Gyeongsangbuk-do 730-340 (KR)
(74) Representative: Patentanwälte Bauer Vorberg Kayser
(86) International application number: PCT/KR2014/007282
(87) International publication number: WO 2015/046746

(56) References cited:
- JP-A- S6 021 900
- JP-A- 2004 256 323
- JP-A- 2007 261 868
- JP-A- 2009 298 652
- JP-A- 2009 298 652
- KR-A- 20030 055 900
- KR-A- 20040 049 357
- KR-B1- 100 411 571

## Description

The present disclosure relates to an ingot growing apparatus in accordance with the preamble of claim 1. Such a device is known from JP 2009 298652 A.

As silicon wafer for manufacturing a semiconductor device become a large diameter, the most silicon wafers are being manufactured from a silicon single crystal ingot that is grown by a Czochralski (CZ) method.

In the CZ method, polysilicon is inserted into a quartz crucible to heat and melt the polysilicon by using a graphite heater, and then a seed contacts the silicon melt to cause crystallization on an interface of the silicon melt. Thereafter, a seed is slowly pulled while rotating to grow a silicon single crystal ingot having a desired diameter.

However, when the polysilicon is melted in the quartz crucible, and the single crystal is grown, upper and lower portions of a graphite crucible may be exposed to the outside. Thus, since the crucible has high thermal conductivity, a large amount of heat may be lost through the upper and lower portions of the graphite crucible.

Also, when heater power increases to compensate the lost heat, a corner portion between the upper and lower portions of the graphite crucible may be concentratedly degraded. Thus, the corner portion may be damaged by the degradation to decrease life-cycles of the graphite and quartz crucibles.

It is the object of the invention to provide a remedy for the drawbacks of the state-of-the-art, especially increase the lifecycle of the graphite and quartz crucibles.

This object is solved by the ingot growing apparatus of claim 1.

Embodiments provide an ingot growing apparatus in which the inside of a graphite crucible is thermally insulated when polysilicon is heated to prevent a specific portion of the crucible from being concentratedly degraded.

The ingot growing apparatus includes: a quartz crucible in which a silicon melt is stored; a graphite crucible in which the quartz crucible is accommodated; a crucible support supporting a lower portion of the graphite crucible; and a heater supplying heat into the graphite crucible, wherein the graphite crucible includes an inner body contacting the quartz crucible and an outer body disposed spaced a predetermined distance from the inner body, and an inert gas is injected between the inner body and the outer body to form an inert gas layer.

According to the proposed embodiments, when the polysilicon is melted, the inside of the crucible may be thermally insulated to reduce the heater power, thereby improving quality of the ingot and reducing manufacturing costs of the ingot.

Also, according to the embodiments, the concentration of the degradation in a specific portion of an inner wall of the crucible may be prevented to prevent the crucible from being damaged by the degradation, thereby increasing a life-cycle of the crucible.
Fig. 1 is a view of an ingot growing apparatus according to an embodiment.
Fig. 2 is a cross-sectional view of a crucible and components in the periphery of the crucible according to an embodiment.
Fig. 3 is a top view of the crucible according to an embodiment.
Fig. 4 is a view of a state in which a heater heats the crucible in which an inert gas layer is not provided according to an embodiment.
Fig. 5 is a view of a state in which the heater heats the crucible in which the inert gas layer is provided according to an embodiment.

Hereinafter, exemplary embodiments will be described in detail with reference to the accompanying drawings. The technical scope of the embodiments will fall within the scope of this disclosure, and addition, deletion and modification of components or parts are possible within the scope of the embodiments.

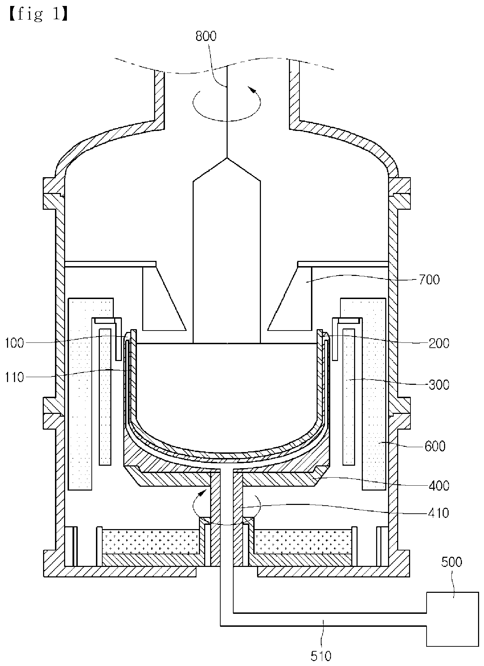

Fig. 1 is a view of an ingot growing apparatus according to an embodiment.

Referring to Fig. 1, an ingot growing apparatus may include a quartz crucible 200 in which a silicon melt can be stored, a graphite crucible 100 supporting the quartz crucible 200, a heater 300 for applying heat, and side and upper insulation units 600 for blocking heat from the inside.

Also, the ingot growing apparatus may further include a support 400 for supporting the graphite crucible 100 and a crucible rotation unit 410 extending from the support 400 to rotate the crucible. Since the crucible rotation unit 410 is vertically movable, the graphite crucible 100 may also be rotated and elevated by the crucible rotation unit 410.

The ingot growing apparatus comprises space 110 and a gas injection hole in the graphite crucible 100. Also, the ingot growing apparatus may further include a gas supply tube 510 connected to the gas injection hole to supply an inert gas into the inner space 110 of the graphite crucible 100 and gas supply units 500 for supplying the inert gas into the gas supply tube 510.

The graphite crucible 100 may include, in addition to crucibles formed of graphite, crucibles formed of a carbon composite material.

Also, a seed rotation shaft 800 to which a single crystal seed may be attached to a lower end thereof may be disposed above the quartz crucible 200. The seed rotation shaft 800 may rotate in a direction different from that of the crucible rotation unit 410. Here, the seed rotation shaft 800 may also be elevated, like the crucible rotation unit 410.

The heater 300 generating heat toward the graphite crucible 100 may serve as a unit for supplying heat to melt polysilicon that is a raw material of the ingot, thereby to form a silicon melt. The side insulation unit 600 may be' disposed outside the heater 300 to thermally insulate the inside of the ingot growing apparatus. The upper insulation unit 700 may be disposed above the silicon melt, and the ingot is pulled by the ascending of the seed rotation shaft 800 into the upper insulation unit 700.

However, when the heater 300 heats the graphite crucible 100, a deviation in heat transfer may occur according to portions of the graphite crucible 100. Thus, degradation of the graphite crucible 100 may be concentrated into a specific portion of the graphite crucible 100 due to the heat transfer deviation.

Also, due to the heat concentration phenomenon, the specific portion of the graphite crucible 100 may be concentratedly damaged. As a result, the graphite crucible 100 may be reduced in life-cycle. Thus, in the embodiment, an inert gas layer may be further provided so that the crucible 100 is more effectively insulated.

That is, to increase the life-cycle of the graphite crucible 100, an inert gas layer may be provided in the inner space of the graphite crucible 100. Here, the inert gas layer may thermally insulate the inside of the graphite crucible 100 to allow heat to be uniformly distributed into the inner wall of the crucible, thereby preventing the specific portion of the graphite crucible 100 from being damaged by the concentration of the degradation. Also, an excessive heat loss to the outside of the crucible may be prevented by the inert gas layer.

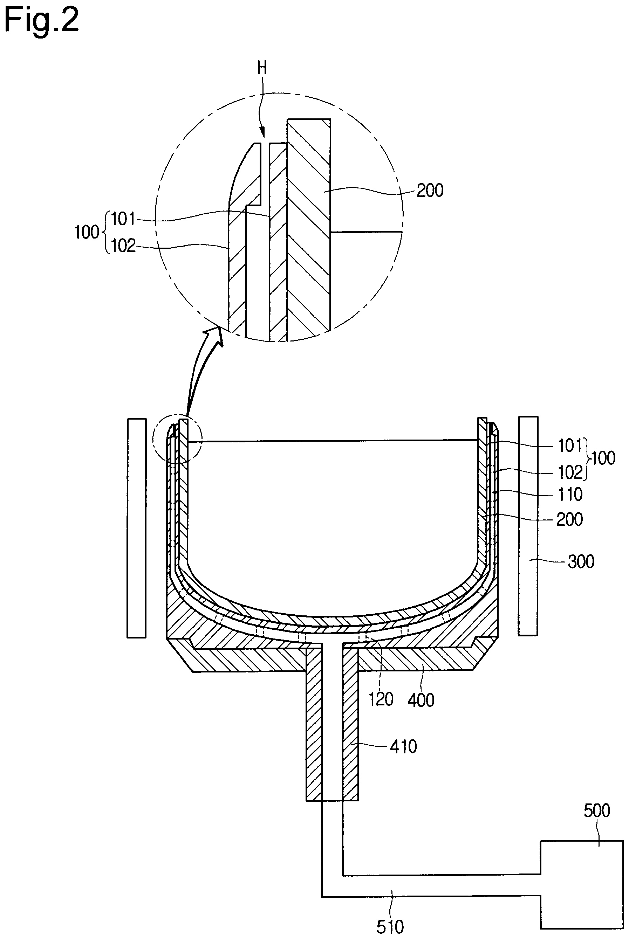

Hereinafter, components according to an embodiment will be described in detail with reference to Fig. 2.

Fig. 2 is a cross-sectional view of the graphite crucible 100 and components in the periphery of the graphite crucible 100 according to an embodiment.

Referring to Fig. 2, a quartz crucible 200 in which the silicon melt is contained is disposed within the graphite crucible 100 to form a dual crucible structure.

When the quartz crucible 200 is under a high-temperature environment by receiving heat from the graphite crucible 100, an oxidized silicon gas (SiOx) may be generated in the quartz crucible. The oxidized silicon gas may react with carbon of the graphite crucible 100 to generate silicon carbide (SiC).

This phenomenon may concentratedly occur at a specific high-temperature portion of the graphite crucible 100, and thus, the silicon carbide may become the cause of damage of the graphite crucible 100.

Also, if the quartz crucible 200 is disposed within the damaged graphite crucible 100, the silicon carbide may be more concentratedly generated in the damaged specific portion of the graphite crucible 100. As a result, the quartz crucible that is in contact with the specific portion may be deformed in shape to reduce the life-cycle of the graphite crucible 100.

Hereinafter, the graphite crucible 100 for preventing the above-described damage from occurring will be described.

A space in which the inert gas according to the embodiment can be stored is defined in the graphite crucible 100. The space 110 in which the inert gas can be filled is defined in the graphite crucible 100.

The graphite crucible 100 comprises an inner body 101 and an outer body 102, which are spaced a predetermined distance from each other, and thus, the space may be defined between the inner body 101 and the outer body 102.

At least one support 120 is disposed between the inner body 101 and the outer body 102.

Thus, at least one support 120 having a predetermined thickness may be provided, and the inert gas may be filled into the inner space 110 of the graphite crucible 100. Here, a space for receiving the inert gas may also be defined between the inner body 101 and the outer body 102, which are disposed on a side surface of the graphite crucible 100. Here, the inert gas may surround the inner body 101 of the graphite crucible 100.

Also, a distance spaced between the inner body 101 and the outer body 102 by the support 120 may be within about 50% of the total thickness of the graphite crucible 100.

For example, if the sum of thicknesses of the inner body 101 and the outer body 102 and a height of the space 110 in which the inert gas can be filled ranges of about 25 mm to about 30 mm, a height (i.e., the distance spaced between the inner body and the outer body by the support) of the space in which the inert gas filled may range of about 10 mm to about 14 mm. If the graphite crucible 100 is formed of a carbon composite material and thus has a thinner thickness, for example, the total thickness ranges of about 8 mm to about 10 mm, the distance spaced between the inner body and the outer body may range of about 3 mm to about 4 mm.

Also, the inner body 101 and the outer body 102 of the graphite crucible 100 may be connected to each other at an upper portion of the graphite crucible 100 to prevent the inert gas from leaking to the outside of the graphite crucible.

However, in case of the graphite crucible 100, carbons constituting graphite may be bonded to each other through van der Was Is bonding having a relatively weak bonding force. Thus, particles may be easily generated at a high temperature, and the inert gas may leak through the outer body. Thus, the silicon within the graphite crucible may be contaminated.

To prevent above-described limitations from occurring, glassy carbon may be applied to a surface of the graphite crucible 100 accommodating the quartz crucible 200 or inner surfaces of the outer and inner bodies which define the inner space of the graphite crucible 100 to enhance strength of the graphite crucible 100 and prevent the inert gas from leaking to the outside.

In the glassy carbon coating method, a thermosetting resin layer may be formed on the surface of the graphite crucible 100 and then dried and thermally treated to carbonize the thermosetting resin into grassy carbon, thereby applying the glassy carbon to the surfaces of the graphite crucible 100 and the outer and inner bodies. Here, a phenolic resin, a furan resin, or a combination thereof may be used as the thermosetting resin.

Since the inert gas forming the inert gas layer has low thermal conductivity, the heat exchange between the inner body 101 and the outer body 102 may be prevented.

That is, the inert gas layer 110 may prevent heat transferred into the graphite crucible 100 from easily leaking to the outside of the crucible. Thus, even though a heater power of the heater 300 decreases, the crucible may be maintained in temperature. Also, the concentration of the degradation into a specific portion of the inner wall of the graphite crucible 100 may be prevented by the insulation effect of the inert gas layer.

Also, the inert gas layer may uniformly distribute heat into the inner wall of the graphite crucible 100 to prevent the degradation from being concentrated and the graphite crucible 100 from being damaged.

In the embodiment, to improve the insulation effect of the inert gas layer, an Ar gas having relatively low thermal conductivity may be used.

However, when the graphite crucible 100 is heated to melt the polysilicon, the inert gas within the graphite crucible 100 may be expanded to damage the graphite crucible 100. Thus, it may be necessary to adjust an inner pressure of the graphite crucible 100 by using the inert gas.

In the embodiment, to adjust the pressure of the graphite crucible 100, an injection hole for injecting the inert gas into the receiving space or inner space may be defined in a lower portion of the graphite crucible 100. Also, a gas supply tube 510 connected to the injection hole to supply or remove the inert gas may be disposed in the lower portion of the graphite crucible 100.

Thus, an amount of inert gas within the inner space may be adjusted to uniformly maintain the inner pressure of the graphite crucible 100.

Hereinafter, components for supplying and removing the inert gas into/from the inner space will be described in detail.

First, the gas supply tube 510 for supplying an inert gas is connected to the gas injection hole that may be defined in the lower portion of the graphite crucible 100.

The gas supply tube 510 passes through a support 400 supporting the graphite crucible 100 to extend in the crucible rotation part 410 along a rotation shaft of the crucible rotation part 410, thereby to be connected to the gas supply unit 500.

The gas supply unit 500 may be disposed outside the chamber to supply the inert gas into the graphite crucible 100 only when the heater 300 operates.

Also, on the other hand, the gas supply unit 500 may suction the inert gas within the graphite crucible 100 to remove the inert gas.

That is, the gas supply unit may form an inert gas layer within the graphite crucible 100 to maintain an amount of inert gas, thereby uniformly maintaining the inner pressure of the graphite crucible 100.

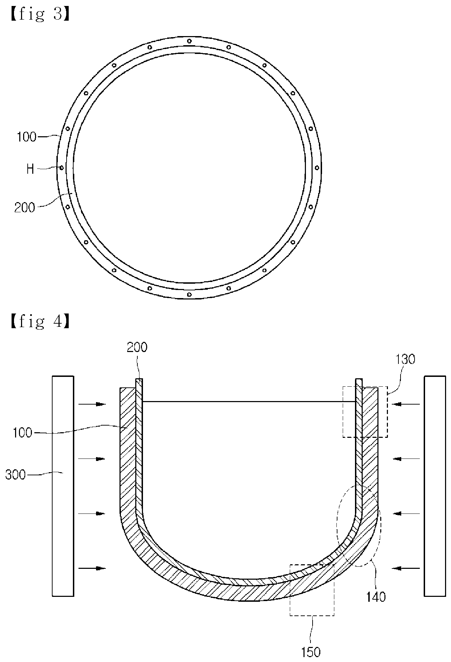

Fig. 3 is a top view of the crucible according to an embodiment.

Referring to Fig. 2, at least one hole H for discharging the inert gas injected into the graphite crucible 100 may be defined in the graphite crucible 100.

When an ingot growing process is performed, foreign substances within the ingot growing apparatus may be absorbed through a gap between an upper end of the graphite crucible 100 and the quartz crucible 200. The upper end of the graphite crucible 100 may be concentratedly damaged by the absorbed foreign substances.

To prevent the above-described phenomenon from occurring, the hole H of the graphite crucible 100 is defined in the top surface of the graphite crucible 100.

Referring to Fig. 3, at least two holes H may be defined in the top surface of the graphite crucible 100 at the same interval.

The inert gas injected into the gas supply unit 500 may be discharged through the hole H to prevent foreign substances from be absorbed through the gap between the graphite crucible 100 and the quartz crucible 200.

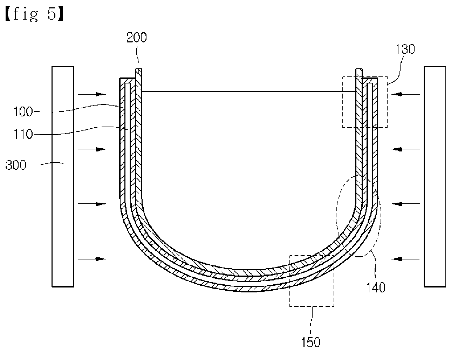

According to the above-described components, the inert gas layer may be provided in the graphite crucible 100. Effects of the inert gas layer may be described with reference to Figs. 4 and 5.

Figs. 4 and 5 are views for explaining a difference in thermal distribution when heat is applied to the graphite crucible 100 according to whether the insert gas layer exists.

The graphite crucible 100 may be divided into an upper part 130, an intermediate part, and a lower port 150, and a process for transferring heat into the graphite crucible 100 from the heater 300 will be described with reference to the upper part 130, the intermediate part, and the lower port 150.

Referring to Fig. 3, when the heater 300 heats the graphite crucible 100, heat is transferred into a side surface of the graphite crucible 100. Here, the intermediate part 140 of the graphite crucible 100 may have a curved shape to connect the side surface of the graphite crucible 100 to a bottom surface of the graphite crucible 100. Thus, a heat transfer area of the intermediate part 140 may increase due to the shape of the graphite crucible 100. As a result, the heat transfer may be concentrated into the intermediate part 140.

Also, since all the upper part 130 and the lower part 150 are exposed to the outside, heat may relatively easily leak through the upper and lower parts 130 and 150 than the intermediate part 140. Also, the heater 300 increases a power thereof to maintain temperature of the upper and lower parts 130 and 150.

That is, the heat transfer may be concentrated into the intermediate part 140 due to the curved shape of the graphite crucible 100, and the degradation may be concentrated into the intermediate part 140 when compared to the surrounding portion thereof because a heat loss to the outside through the intermediate part 140 is relatively low.

Thus, a portion of the quartz crucible 200 contacting the intermediate part 140 is under a high-temperature environment having a temperature greater than that of the surrounding portion thereof. Due to the high-temperature environment, a portion of the quartz crucible 200 may further promote an occurrence of the oxidized silicon gas. Thus, the oxidized silicon gas and the carbons of the graphite crucible 100 may react with each other to promote generation of the silicon carbide.

The silicon carbide may be easily separated from the graphite crucible 100 when the graphite crucible 100 is cleaned. Thus, the graphite crucible 100 may be damaged and deformed by the separated silicon carbide and thus reduced in life-cycle.

Particularly, the intermediate part 140 has a curved portion. As a result, the silicon carbide may be permeated into the curved portion, and thus the curved portion may be easily broken when the quartz crucible 200 is inserted into the graphite crucible 100. Here, the heat and gas may more actively flow along the broken portion or the deformed portion to promote the damage of the graphite crucible 100. Thus, the life-cycle of the graphite crucible 100 may be determined by the damaged degree of the intermediate part 140.

Referring to Fig. 4, to prevent the intermediate part 140 from being damaged, the inert gas layer is provided in the graphite crucible 100.

Since the inert gas layer has very low thermal conductivity, it may be difficult to release heat transferred into the graphite crucible 100 to the outside. Particularly, although the upper and lower parts 130 and 150 of the graphite crucible 100 exposed to the outside release a relatively large amount of heat through the graphite crucible 100 having high thermal conductivity, the inert gas layer having low thermal conductivity may be formed to prevent the heat from being released.

Thus, when the graphite crucible 100 is heated, the graphite crucible 100 may be sufficiently heated at a relatively low power than the required power.

Due to the inert gas layer, heat leaking through the upper and lower parts 130 and 150 of the graphite crucible 100 may be reduced, and the concentration of the degradation into only the intermediate part 140 may be reduced. Also, an amount of heat transferred from an outer wall of the intermediate part 140 into an inner wall of the intermediate part 140 may be reduced to prevent the degradation from concentratedly occurring in the intermediate part 140.

As a result, due to the inert gas layer, the graphite crucible 100 may have uniform heat distribution over the entire area thereof to prevent the degradation from being concentrated into a specific portion. Thus, the damage of the graphite crucible 100 due to the concentration of the degradation may be prevented.

As described above, in the ingot growth apparatus, the heater power may be reduced by thermally insulating the inside of the graphite crucible 100. Also, the concentration of the degradation into a specific portion of the graphite crucible 100 may be prevented to increase the life-cycle of the graphite crucible 100. Therefore, the production costs of the ingot may be reduced.

Accordingly, a person having ordinary skill in the art will understand from the above that various modifications and other equivalent embodiments are also possible.

The embodiment provides the ingot growing apparatus for growing an ingot for a wafer and the crucible used in the ingot growing apparatus, and thus, industrial usability is high.

## Claims

1. An ingot growing apparatus comprising:
a quartz crucible (200) in which a silicon melt is stored;
a graphite crucible (100) in which the quartz crucible (200) is accommodated;
a crucible support (120) supporting a lower portion of the graphite crucible (100);
a heater (300) supplying heat into the graphite crucible (100), and
a gas supply unit (500) for supplying the inert gas into the graphite crucible (100),
wherein the graphite crucible (100) comprises an inner body (101) contacting the quartz crucible (200) and an outer body (102) disposed spaced a predetermined distance from the inner body (101), and a space (110) is defined between the inner body (101) and the outer body (102), wherein the space of the graphite crucible (100) is filled with an inert gas, **characterized in that** at least one hole (H) is defined in a top surface of the graphite crucible (100) and the inert gas supplied by the gas supply unit (500) is discharged through the hole (H).

2. The ingot growing apparatus according to claim 1,
wherein the inert gas supplied through the gas supply unit (500) passes through the crucible support (400) and is provided through a lower portion of the graphite crucible (100).

3. The ingot growing apparatus according to claim 1, wherein the gas supply unit (500) supplies the inert gas into the graphite crucible (100) when the heater (300) operates.

4. The ingot growing apparatus according to claim 1, wherein the inert gas comprises argon (Ar) gas.

5. The ingot growing apparatus according to claim 1, wherein at least one support (120) having a predetermined thickness is formed between the inner and outer bodies of the graphite crucible (100).

6. The ingot growing apparatus according to claim 1, wherein the support (120) has a height of about 50% or less of a thickness of the graphite crucible (100).

7. The ingot growing apparatus according to claim 1, wherein grassy carbon is applied to at least one surface of the graphite crucible (100).

8. The ingot growing apparatus according to claim 1, wherein at least one surfaces of the outer and inner bodies (102, 101) contacting the inert gas layer is coated with grassy carbon.

9. The ingot growing apparatus according to claim 1, **characterized in that** at least two holes (H) are defined in the top surface of the graphite crucible (100) and the inert gas supplied by the gas supply unit (500) is discharged through the holes (H)

## Patentansprüche

1. Eine Barrenzuchtvorrichtung, umfassend:
einen Quarztiegel (200), in dem eine Siliziumschmelze gespeichert ist; einen Graphittiegel (100), in dem der Quarztiegel (200) untergebracht ist; einen Tiegelträger (120), der einen unteren Abschnitt des Graphittiegels (100) trägt;
eine Heizvorrichtung (300), die Wärme in den Graphittiegel (100) liefert, und eine Gasversorgungseinheit (500) zum Zuführen des Inertgases in den Graphittiegel (100), wobei der Graphittiegel (100) einen inneren Körper (101), der den Quarztiegel (200) kontaktiert, und einen äußeren Körper (102) umfasst, der in einem vorbestimmten Abstand vom inneren Körper (101) angeordnet ist, und ein Raum (110) zwischen dem inneren Körper (101) und dem äußeren Körper (102) definiert ist, wobei der Raum des Graphittiegels (100) mit einem Inertgas gefüllt ist, **dadurch gekennzeichnet, dass** mindestens ein Loch (H) in einer Oberseite des Graphittiegels (100) definiert ist und das von der Gasversorgungseinheit (500) zugeführte Inertgas durch das Loch (H) abgegeben wird.

2. Die Barrenzuchtvorrichtung nach Anspruch 1, wobei das durch die Gasversorgungseinheit (500) zugeführte Inertgas durch den Tiegelträger (400) hindurchgeht und durch einen unteren Abschnitt des Graphittiegels (100) bereitgestellt wird.

3. Die Barrenzuchtvorrichtung nach Anspruch 1, wobei die Gasversorgungseinheit (500) das Inertgas in den Graphittiegel (100) einspeist, wenn die Heizvorrichtung (300) arbeitet.

4. Die Barrenzuchtvorrichtung nach Anspruch 1, wobei das Inertgas Argon (Ar) Gas umfasst.

5. Die Barrenzuchtvorrichtung nach Anspruch 1, wobei mindestens ein Tiegelträger (120), der eine vorbestimmte Dicke aufweist, zwischen dem inneren und dem äußeren Körper des Graphittiegels (100) ausgebildet ist.

6. Barrenzuchtvorrichtung nach Anspruch 1, wobei der Tiegelträger (120) eine Höhe von etwa 50% oder weniger einer Dicke des Graphittiegels (100) aufweist.

7. Barrenzuchtvorrichtung nach Anspruch 1, wobei Graskohlenstoff auf mindestens eine Oberfläche des Graphittiegels (100) aufgebracht ist.

8. Barrenzuchtvorrichtung nach Anspruch 1, wobei mindestens eine Oberfläche des äußeren und inneren Körpers (102, 101), die die Inertgasschicht berührt, mit Graskohlenstoff beschichtet ist.

9. Die Barrenzuchtvorrichtung nach Anspruch 1, **dadurch gekennzeichnet, dass** in der Oberseite des Graphittiegels (100) mindestens zwei Löcher (H) definiert sind und das von der Gasversorgungseinheit (500) zugeführte Inertgas durch die Löcher (H) abgegeben wird.

## Revendications

1. Appareil de culture de lingot comprenant :
un creuset en quartz (200) dans lequel est stockée une masse fondue de silicium ;
un creuset en graphite (100) dans lequel est logé le creuset en quartz (200) ; un support de creuset (120) supportant une partie inférieure du creuset en graphite (100) ; un dispositif de chauffage (300) fournissant de la chaleur dans le creuset en graphite (100), et une unité d'alimentation en gaz (500) pour alimenter le gaz inerte dans le creuset en graphite (100), où le creuset en graphite (100) comprend un corps intérieur (101) en contact avec le creuset en quartz (200) et un corps extérieur (102) disposé à une distance prédéterminée du corps intérieur (101), et un espace (110) est défini entre le corps intérieur (101) et le corps extérieur (102), où l'espace du creuset en graphite (100) est rempli d'un gaz inerte, **caractérisé en ce qu'**au moins un trou (H) est défini dans une surface supérieure du creuset en graphite (100) et le gaz inerte fourni par l'unité d'alimentation en gaz (500) est évacué par le trou (H).

2. Appareil de culture de lingot selon la revendication 1, dans lequel le gaz inerte fourni par l'unité d'alimentation en gaz (500) traverse le support de creuset (400) et est fourni par une partie inférieure du creuset en graphite (100).

3. Appareil de croissance de lingot selon la revendication 1, dans lequel l'unité d'alimentation en gaz (500) fournit le gaz inerte dans le creuset en graphite (100) lorsque le dispositif de chauffage (300) fonctionne.

4. Appareil de croissance de lingot selon la revendication 1, dans lequel le gaz inerte comprend du gaz argon (Ar).

5. Appareil de croissance de lingot selon la revendication 1, dans lequel au moins un support (120) ayant une épaisseur prédéterminée est formé entre les corps intérieur et extérieur du creuset en graphite (100).

6. Appareil de culture de lingot selon la revendication 1, dans lequel le support (120) a une hauteur d'environ 50% ou moins d'une épaisseur du creuset en graphite (100).

7. Appareil de croissance de lingot selon la revendication 1, dans lequel du carbone herbeux est appliqué sur au moins une surface du creuset en graphite (100).

8. Appareil de croissance de lingot selon la revendication 1, dans lequel au moins une surface des corps extérieur et intérieur (102, 101) en contact avec la couche de gaz inerte est revêtue de carbone herbeux.

9. Appareil de croissance de lingot selon la revendication 1, **caractérisé en ce qu'**au moins deux trous (H) sont définis dans la surface supérieure du creuset en graphite (100) et le gaz inerte fourni par l'unité d'alimentation en gaz (500) est évacué par les trous (H)
